Europäisches Patentamt

European Patent Office

Office européen des brevets

(11) Publication number:

**0 361 818**
**A2**

# EUROPEAN PATENT APPLICATION

(21) Application number: 89309706.3

(22) Date of filing: 25.09.89

(51) Int. Cl.⁵: **B25B 11/00 , H05K 13/00**

(30) Priority: 27.09.88 US 250029

(43) Date of publication of application:
04.04.90 Bulletin 90/14

(84) Designated Contracting States:
AT BE CH DE ES FR GB GR IT LI LU NL SE

(71) Applicant: W.R. Grace & Co.-Conn.
1114 Avenue of the Americas
New York New York 10036(US)

(72) Inventor: Merjanian, John-Michael
6 Dolores Drive
Burlington, Massachusetts 01803(US)

(74) Representative: Barlow, Roy James et al
J.A. KEMP & CO. 14, South Square, Gray's
Inn
London WC1R 5EU(GB)

(54) **Universal platen holddown apparatus.**

(57) Disclosed is a universal platen holddown appara-
tus that includes a first plate (16) rotatable about its
central axis, and a second plate (29) that is rotatable
about its own central axis. The first plate is mounted
within the second plate so that rotation of the second
plate results in the eccentric rotation of a vacuum
suction cup (14) mounted at or near a rim of the first
plate. This arrangement allows the suction cup to be
moved to any location within the boundaries of the
second plate.

FIG. I

EP 0 361 818 A2

# UNIVERSAL PLATEN HOLDOWN APPARATUS

## BACKGROUND OF THE INVENTION

The present invention relates to an apparatus for holding a workpiece, and more particularly to an apparatus for vacuum holding a printed circuit board substrate of any shape or size.

During the manufacture of printed circuit boards in which a printed circuit board substrate is exposed to ultraviolet light, the substrate must be securely positioned on a work surface. One type of holding apparatus secures the substrate on a work table by applying vacuum through the work table. The vacuum, however, does not always provide an effective hold, especially if the surfaces of the substrate are not perfectly flat. For example, warped circuit board substrates do not lie flat on a work table, and as a result vacuum holding ability is less than optimal. In addition, the circuit board substrates often contain through holes which prevent the vacuum holddown of the substrate.

Another common problem encountered with the use of existing holddown apparatus is that they are designed to handle a workpiece of a single preset size, and it is often necessary to process a variety of printed circuit boards substrate sizes. United States Patent No. 4,468,017 describes one type of vacuum holddown apparatus that is designed to handle a variety of workpiece sizes by utilizing a vacuum zone control valve for selectively applying vacuum to certain regions on the table. One disadvantage of such a system is that the location of the vacuum source on the work table is preset and can not be moved to a location where the vacuum holding power can more efficiently operate on the workpiece.

It is therefore a principal object of the present invention to provide a vacuum holddown apparatus that will hold a printed circuit board substrate having an uneven surface.

It is another object of the present invention to provide vacuum holddown apparatus that will hold a variety of different sizes of printed circuit board substrates.

## SUMMARY OF THE INVENTION

The universal platen holddown apparatus of the present invention includes a first plate that is rotatable about its central axis, and a second plate that is rotatable about its own central axis. The first plate is mounted within the second plate so that rotation of the second plate results in the eccentric rotation of a vacuum suction cup mounted near the rim of the first plate. This arrangement allows the suction cup to be moved to virtually any location within the boundaries of the second plate.

By arranging a plurality of the two-plate assemblies, vacuum suction can be applied to different locations on a workpiece. In a preferred embodiment, the plate assemblies are arranged so that the workpiece is held at each of its four corners and in one or more central locations.

These and other objects and features of the present invention will become more clearly understood from the following detailed description which should be read in light of the accompanying drawings in which corresponding reference numerals refer to corresponding parts throughout the several views.

## BRIEF DESCRIPTION OF THE DRAWINGS

Fig. 1 is a top plan view of a single disc assembly of a universal platen holddown apparatus of the present invention;

Fig. 2 is a top plan view of a platen assembly including five of the disc assemblies sown in Fig. 1;

Fig. 3 is a top perspective view, with a portion cut out, of the smaller disc of the disc assembly shown in Fig. 1;

Fig. 4 is a bottom perspective view of the shown in Fig. 3;

Fig. 5 is a side elevational view of a portion of the universal holddown apparatus shown in Fig. 1, including the disc shown in Figs. 3 and 4.

## DETAILED DESCRIPTION OF THE PREFERRED EMBODIMENT

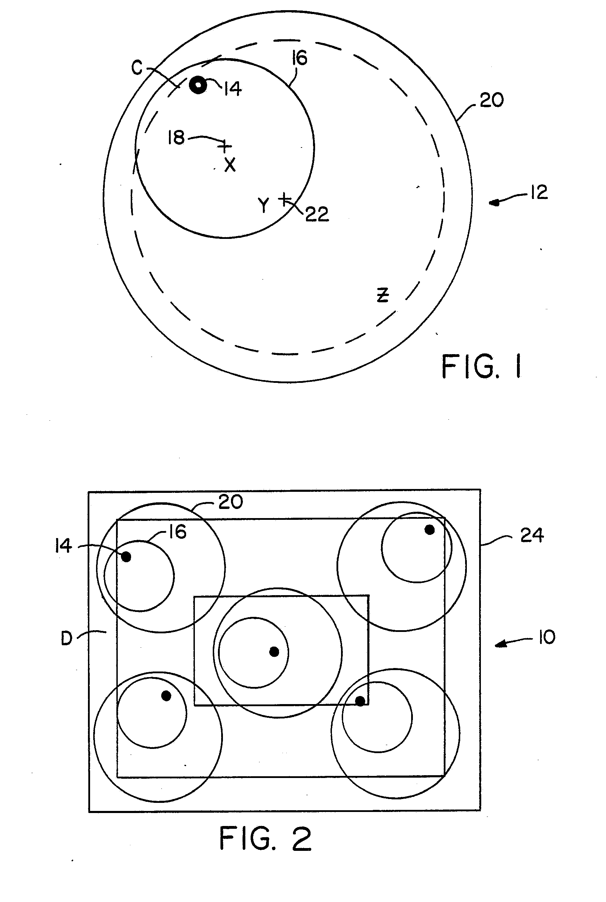

Referring to Fig. 1, a universal platen holddown apparatus 10 of the present invention includes at least one plate assembly 12. Each plate assembly includes a bellow style vacuum cup 14 mounted on the rim of a circular plate 16. Circular plate 16 is mounted for rotation about its central axis 18, and a second larger circular plate 20 is mounted for rotation about its own central axis 22. Rotation of the second circular plate 20 causes the eccentric rotation of plate 16 about axis 22.

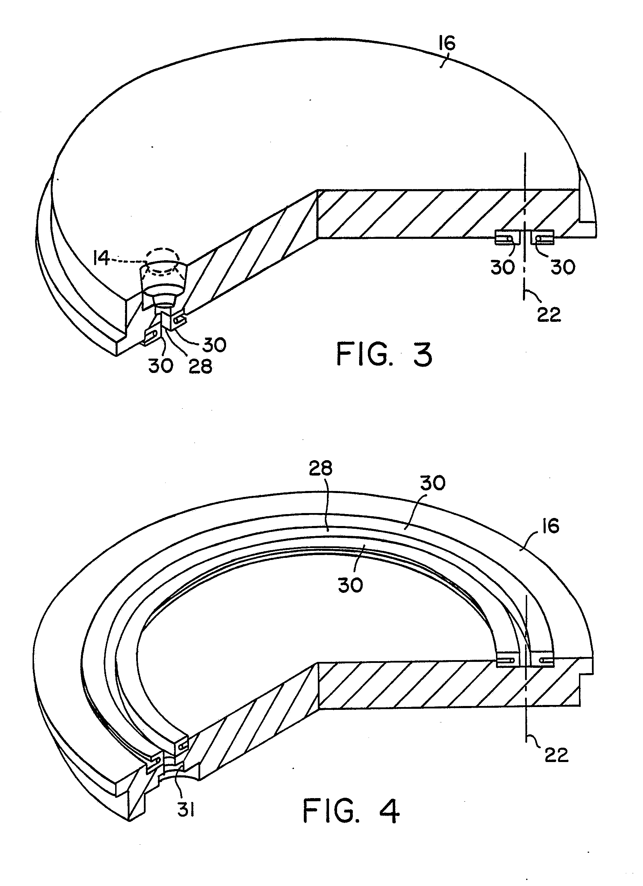

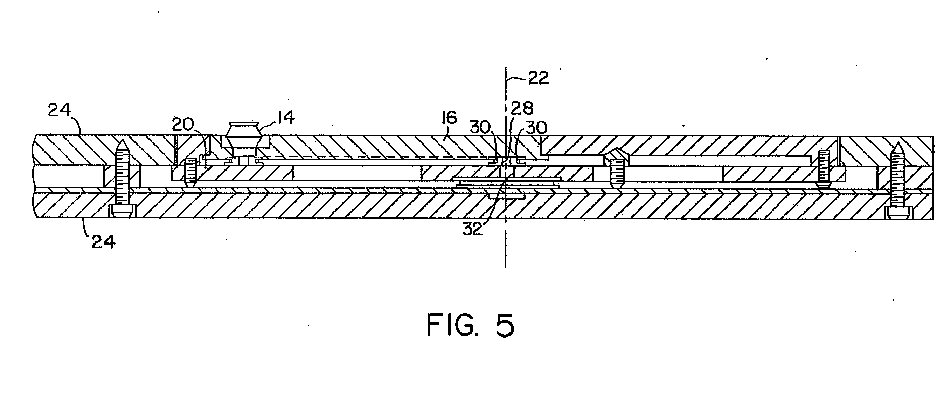

The two flat plates 16, 20 are embedded in a platen or table 24 to provided complete support for the workpiece on a level image plane as is needed to provided a support for the substrate. Without requiring deep slots in the platen 24, the suction cup 14 can move radially (between circumference Z and point Y) in relation to large plate 20 by rotating small plate 16. The cup 14 can also be moved angularly about axis 22 so that the cup has full motion in the area of the large circle defined by circumference Z. The vacuum is carried through the plate assembly 12, connecting to plate ·16 at the axis 22 of the plate 20 as will be described below with reference to Figs. 3-5.

Referring to Fig. 2, the five plate assemblies 12 are arranged on a single work table 24 to provide holddown vacuum source in the center and at the four corners of a workpiece, the perimeter of which falls within the area D outlined in the Figure. When a void is located that would prevent a vacuum occurring, a fine adjustment of the plates provides a suction cup placement at the appropriate location.

Referring now to Figs. 3-5, each circular plate 16 includes a narrow circular channel 28 between two seals 30. The suction cup 14 is positioned over channel 28 so that the lower end of the suction cup communicates with an opening 31 through the plate 16 to the channel 28. A vacuum source is applied to channel 28 through nozzle 32 which communicates with channel 28 from below circular plate 16. Nozzle 32 is aligned with axis 22 and remains aligned therewith when the circular plate 16 and/or 20 rotate. Channel 28 on the underside of plate 16 is sealed at the top surface of circular plate 20.

While the foregoing invention has been described with reference to its preferred embodiments, various alterations and modifications will occur to those skilled in the art. All such alterations and modifications are intended to fall within the scope of the appended claims.

## Claims

1. An apparatus for securely holding workpieces on a table through the application of a vacuum source through the table (24), said apparatus comprising;
means for applying a vacuum source to a workpiece through an opening (14) through said table; and
means (16, 20) for moving said opening through which the vacuum source is applied to the workpiece.

2. Workpiece holddown apparatus according to claim 1, comprising:- a first plate (16) rotatable about a central axis (18) thereof; and a second plate (20) rotatable about a central axis (22) thereof, said second plate being larger than said first plate and entirely encircling said first plate which is mounted on said second plate; wherein said opening is in said first plate.

3. Workpiece holddown apparatus according to claim 2, wherein said first plate (16) is mounted at a location on said second plate (20) so that said first plate rotates in an eccentric fashion about said central axis of the second plate.

4. Workpiece holddown apparatus according to claim 2 or 3, wherein a top surface of said first plate is flush with a top surface of said table.

5. Workpiece holddown apparatus according to any one of claims 2 to 4, wherein said means (14) for applying a vacuum can be positioned at any location within the surface area of said second plate.

6. Workpiece holddown apparatus according to claim 5, wherein said first plate is rotatable 360° about its said central axis and said second plate is rotatable 360° about its said central axis.

7. Workpiece holddown apparatus according to claim 5 to 6, wherein said means for applying a vacuum source comprises means (32) for connecting a vacuum source to said first plate along said central axis of the second plate.

8. Workpiece holddown apparatus according to any one of claims 2 to 7, and comprising a plurality of said first and second plates.

9. Workpiece holddown apparatus according to any one of claims 2 to 8, wherein said means for applying a vacuum source comprises a suction cup (14) mounted at or near the outer perimeter of said first plate.

10. Workpiece holddown apparatus according to any one of claims 2 to 9, wherein said first plate comprises:
a channel (28) formed between two seals (30) positioned along a bottom surface of said first plate (16), said channel communicating with the upper side of said first plate through an opening said first plate extending from said channel to the top surface of said first plate; and means for applying a vacuum source to said channel and through said opening.

11. Workpiece holddown apparatus according to claim 10 when appendant to claim 9, wherein said suction cup is positioned within said first plate in communication with said opening.

FIG. 1

FIG. 2

16

14

30
30  28

30  30

22

FIG. 3

28

30

30

16

22

31

FIG. 4

FIG. 5